(19) Europäisches Patentamt
European Patent Office
Office européen des brevets

(11) **EP 4 354 523 A1**

(12) **EUROPEAN PATENT APPLICATION**
published in accordance with Art. 153(4) EPC

(43) Date of publication:
**17.04.2024 Bulletin 2024/16**

(21) Application number: **22819689.5**

(22) Date of filing: **07.06.2022**

(51) International Patent Classification (IPC):
**H01L 31/054** (2014.01)     **H01L 31/068** (2012.01)

(52) Cooperative Patent Classification (CPC):
Y02E 10/52

(86) International application number:
**PCT/ES2022/070353**

(87) International publication number:
**WO 2022/258868 (15.12.2022 Gazette 2022/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.06.2021 ES 202130520**

(71) Applicant: **Universidad de Jaén
23071 Jaén (ES)**

(72) Inventors:
- **FERNÁNDEZ FERNÁNDEZ, Eduardo
  23071 Jaén (ES)**
- **ALMONACID CRUZ, Florencia Marina
  23071 Jaén (ES)**
- **RODRIGO CRUZ, Pedro Manuel
  23071 Jaén (ES)**
- **PÉREZ HIGUERAS, Pedro Jesús
  23071 Jaén (ES)**

(74) Representative: **Herrero & Asociados, S.L.
Edificio Aqua - Agustín de Foxá, 4-10
28036 Madrid (ES)**

(54) **SEMI-TRANSPARENT BIFACIAL PHOTOVOLTAIC MODULE WITH REAR IRRADIANCE CONCENTRATORS**

(57)     Semi-transparent photovoltaic module that comprises a front glass cover (1) and a rear glass cover (4), an array of bifacial cells (2) with a separation area between them and an array of rear refractive concentrators (3) that concentrate the rear light onto the rear surface of the bifacial cells. The invention is especially useful in photovoltaic agriculture applications for plantations that require a high level of insolation, or in integration into buildings that require high interior lighting.

FIG. 1

## Description

The present invention falls within the technical area/sector of photovoltaic energy; specifically, it is related to photovoltaic modules, for example for agriculture and integration in buildings.

## BACKGROUND OF THE INVENTION

Semi-transparent photovoltaic modules convert part of the incident irradiance into electricity, while unabsorbed irradiance is transmitted by the device. This allows different applications, such as in photovoltaic agriculture, where the transmitted irradiance is used for plantations (whether outdoor plantations or in greenhouses) to carry out photosynthesis, or in architectural integration in buildings, where the transmitted irradiance serves to illuminate the interior and perform aesthetic functions. Today there are two types of photovoltaic technology that allow semi-transparency to be obtained. On the one hand, the use of thin films of semiconductor materials such as amorphous silicon, copper-indium-gallium-selenium (CIGS), cadmium-tellurium (CdTe), quantum dot cells, organic polymers, dye-sensitized cells or perovskites, which have a certain degree of transparency in themselves, allowing transparency levels between 9% of the incident light and 54% (Kangmin Lee et al., "The Development of Transparent Photovoltaics", Cell Reports Physical Science 1, 100143, August 26 2020, Table 1). On the other hand, the use of opaque crystalline silicon cells, which are configured with a separation area in the module, so that there is a transparent area part (glass) and an opaque area part (photovoltaic cell). In this configuration, the larger the separation area between cells, the greater the degree of transparency. There are commercial products that use this last concept. For example, the German company BISOL Solar Company markets the BISOL Lumina series, which uses monocrystalline or polycrystalline silicon cells with transparency factors between 5.3% and 53.6% (https://www.bisol.com/pv-modules). Of the two types of semi-transparent photovoltaic technology, today the crystalline silicon option tends to be used more due to the abundance of silicon, its low cost and its reliability.

A limitation of these semi-transparent silicon modules is that the higher the level of transparency, the lower the efficiency of the device, as the amount of active area is reduced. There are applications that require a high level of transparency, for example in agriculture, where certain types of plants require high sun exposure to avoid losing production. A direct way to increase the electrical production of these semi-transparent modules is to use bifacial cells that, by capturing both the front and rear irradiance, increase the electrical production compared to monofacial cells, with a minimum increase in the cost of the device.

There are several patents that use concentrators in conjunction with bifacial cells to increase the electrical production of bifacial modules:

US Patent No. 5538563, dated July 23, 1996, by Anthony W. Finkl: Uses flat, pyramid-shaped reflectors and bifacial cells mounted either vertically or horizontally. The concentrators receive the incident irradiance and deflect it towards both sides of the bifacial cells.

United States Patent No. US 2012/0097213 A1, dated April 26, 2012, by Plkington Group Limited: Uses a flat reflective plate parallel to a semi-transparent bifacial active surface, in such a way that the irradiance transmitted by the active area is reflected and returned to the rear face of the active surface.

United States Patent No. 4169738, dated October 2, 1979, by Antonio Luque. A paraboloid-shaped reflective concentrator is used that concentrates the incident irradiance on a bifacial cell located within the volume of the concentrator. This volume is filled with a fluid that helps cooling and fin heat sinks are incorporated in the back.

United States Patent No. US 2010/0126556A1, dated May 27, 2010, by Light Prescriptions Innovators: In this high concentration system, Fresnel lenses are used to focus direct irradiance on a main cell, which is surrounded by bifacial cells responsible for absorbing diffuse irradiance and albedo.

European Patent No. EP 1 732 141 A1, dated December 13, 2006, by The General Electric Company Schenectady: In this system, the front cover has a flat surface and a molded surface capable of concentrating and guiding light on the cell arrays bifacial. German Patent No. DE 20 2014 105 516, dated February 5, 2015, by SolarWorld AG: In this system, at least two arrays of bifacial modules are mounted in a vertical position parallel to each other, and a reflector is incorporated in a horizontal position in the base of the structure to increase the irradiance incident on the surfaces of the modules.

United States Patent No. US 2016/0284.914 A1, dated September 29, 2016, by BAKERSUN: In this system, at least one bifacial module is mounted in a horizontal position elevated with respect to the ground and a reflector is incorporated in the back in the shape triangular or semi-cylinder prism to increase the irradiance received by the rear surface of the module.

All of the devices described above are characterized by the use of concentrators that redirect the irradiance received frontally towards the bifacial cells to increase their electrical production. However, the use of these concentrators implies reducing or eliminating the transparency of the system. Therefore, they are not suitable for semi-transparent bifacial photovoltaic modules.

## SUMMARY OF THE INVENTION

The purpose of the invention is to increase the electrical production capacity of the semi-transparent bifacial modules, by concentrating the subsequent light rays, mainly coming from the reflection of the ground and nearby objects.

To this end, the semi-transparent bifacial photovoltaic module of the invention incorporates refractive concentrators in its rear part, that is, in the part furthest from the main entrance face of the solar rays or intended to be placed closer to the ground. These concentrators allow the passage of frontal irradiance, ensuring the required degree of transparency, while redirecting rear irradiance, directing it towards the rear face of the bifacial cells. With this strategy, ideally, all subsequent radiation can be used without affecting the degree of transparency.

Although the use of concentrators to improve the electricity production capacity of bifacial modules is not new, existing inventions have focused on concentrating or redirecting the frontal irradiance, reducing or eliminating the semi-transparency of the modules. The solution proposed in this invention ensures the level of transparency required by the application and contributes to increasing the energy production capacity of the bifacial modules, making it suitable for photovoltaic agriculture and for integration into buildings.

## BRIEF DESCRIPTION OF THE FIGURES

In order to help a better understanding of the characteristics of the invention and to complement this description, the following figures are attached as an integral part of it, the nature of which is illustrative and not limiting:

Fig. 1 shows a schematic of the structure of the semi-transparent bifacial photovoltaic module with rear refractive concentrators. Crossed V-channel refractive concentrators are shown in the figure as an example.

Fig. 2 shows a range of seven refractive concentrators that can be integrated into the semi-transparent bifacial module. In addition to these, other variants of refractive concentrators can be integrated.

Fig. 3 shows the relationship between the transparency factor of the semi-transparent bifacial photovoltaic module and its power gain compared to a semi-transparent monofacial module with the same transparency factor, considering a low optical efficiency (0.40) and a high optical efficiency (0.70), for Bifaciality = 0.85, Frontal Irradiance = 1000 W/m2 and Rear irradiance = 300 W/m2.

## DETAILED DESCRIPTION

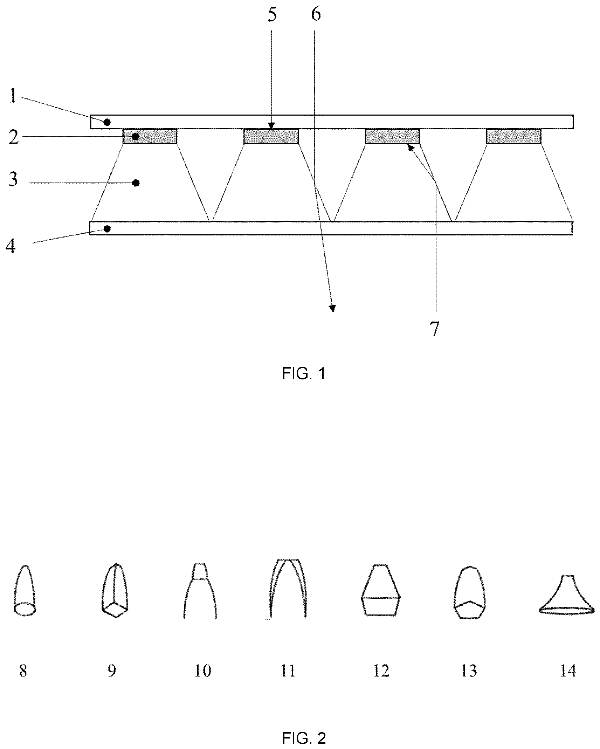

The present invention is related to a semi-transparent bifacial photovoltaic module with rear refractive concentrators that allow increasing the electrical energy generation capacity by redirecting the light rays that subsequently fall towards the rear face of the bifacial cells, maintaining the degree of semi-transparency required by the application, with use in photovoltaic agriculture or in integration in buildings. The invention makes it possible to take advantage of all the subsequent radiation that falls on the module without affecting the degree of transparency. Referring to Figure 1, the module is composed of two sheets of tempered glass with anti-reflective treatment (front sheet 1 and rear sheet 4), a matrix of bifacial cells 2 under the front glass sheet that maintain a separation area between them to achieve the desired degree of transparency and a matrix of rear refractive concentrators 3 under the rear face of the bifacial cells, each cell having an associated concentrator, that is, placed with its front face in direct correspondence with the cell. The bifacial cells are electrically interconnected to allow a two-wire output of electrical power. Refractive concentrators have an upper or front area equal to the area of the bifacial cell and a larger lower or rear area to capture as much rear irradiance as possible, so that the optical system formed by all the different units covers the entire rear area of the module in order to accept all the subsequent incident irradiance.

The principle of operation of the module can be summarized as follows: a part of the light rays arriving frontally 5 fall directly on the front face of the bifacial cells; the rest of the light rays arriving from the front 6 pass through the module allowing the required degree of transparency; light rays arriving rearly 7 are redirected by total internal reflection by the rear refractive concentrators towards the rear face of the bifacial cells. In this way, more of the rear irradiance can be converted into electricity compared to a bifacial module without rear concentrators.

Rear concentrators, made of refractive material, can take various shapes. Referring to Figure 2, the different types of concentrators shown (which are not the only ones that exist) are:

8- Revolution compound parabolic concentrator;
9 - Cross compound parabolic concentrator;

10 - Compound parabolic concentrator;
11 - Compound parabolic concentrator with lens walls;
12 - Cross V-channel concentrator;
13 - Polygonal compound parabolic concentrator;
14 - Square elliptical hyperboloid.

These types of concentrators are commonly used as front irradiance concentrators in low concentration photovoltaic systems, reaching geometric concentration levels of up to 10x, or as a secondary optical element in high concentration systems capable of concentrating front irradiance up to 2000x (Shanks et al., "Optics for concentrating photovoltaics: Trends, limits and opportunities for materials and design", Renewable and Sustainable Energy Reviews 60 (2016) 394-407). In the present invention they are used for the first time as rear irradiance concentrators. It should be noted that low geometric concentration levels up to 10x allow bifacial modules to be mounted in a fixed structure, avoiding the use of solar trackers in applications.

The power gain obtained by the semi-transparent bifacial module with subsequent concentrators compared to a semi-transparent monofacial module can be calculated as:

$$\text{Gain (\%)} = (\text{Rear irradiance} * \text{Bifaciality} * \text{Optical Efficiency}) / [\text{Front Irradiance} * (1 - \text{Transparency Factor})] * 100$$

The gain margins of the invention can then be obtained considering the following margins for the parameters: Transparency factor: 0.50 - 0.90; Bifaciality: 0.80 - 1.00; Optical efficiency: 0.40 - 0.70; Front irradiance: 1000 W/m2; Rear irradiance: 100 - 300 W/m2. This results in a gain margin between 6.4% and 210% depending on the configuration.

The maximum geometric concentration of the refractive concentrators is a function of the transparency factor, according to the formula:

$$\text{Maximum concentration} = 1 / (1 - \text{Transparency factor})$$

According to this formula, for a Transparency Factor range between 0.50 and 0.90, a maximum concentration between 2x and 10x is obtained. These concentration levels can be obtained with refractive concentrator types 8, 9, 10, 11, 12, 13, 14 or other refractive concentrator variants.

As an example of embodiment of the invention, a semi-transparent bifacial photovoltaic module with rear concentrators is described below where the photovoltaic cells have a Bifaciality = 0.85 and the rear concentrators have an Optical Efficiency = 0.50. For this, commercial bifacial cells and optical concentrators of the crossed V-channel type 12 are used.

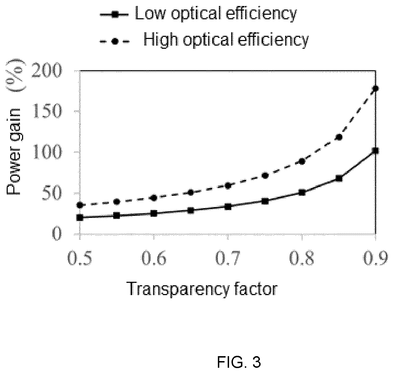

Both the design of the subsequent concentrators and the gain obtained by the module compared to a semi-transparent monofacial depend largely on the Transparency Factor required by the application. The design of the rear concentrators should be adapted so that the collection area is as large as possible while the area into which they concentrate the rear light should match the area of the bifacial cell. In the case of crossed V-channel type concentrators 12, the collection area can be adapted to the total collection area of the module by having a square opening, maximizing the capture of subsequent irradiance. The power gain obtained by the semi-transparent bifacial module with subsequent concentrators is a function of the Transparency Factor, as represented in Fig. 3 for a high optical efficiency (0.70) and a low optical efficiency (0.40). Depending on the Transparency Factor, and considering in this embodiment an optical efficiency of 0.50, gains between 25.5% and 127.5% can be obtained, applying a Front Irradiance = 1000 W/m2 and a Rear Irradiance = 300 W/m2.

The invention is therefore especially useful in applications that require a high degree of transparency. As an example of embodiment, the invention can be used in agricultural applications, for plantations that require a high degree of sunshine to ensure their production. In this case, a transparency factor = 0.80 is chosen. The module is configured with rear refractive concentrators of 5x geometric concentration to obtain a power gain of 63.8%. This is equivalent to an electrical power production per unit module area of 65.5 W/m2, compared to the 40 W/m2 that a monofacial module with the same degree of semi-transparency would produce.

In view of this description and figure, the person skilled in the art will be able to understand that the invention has been described according to some preferred embodiments thereof, but that multiple variations can be introduced in said preferred embodiments, without exceeding the object of the invention as it has been claimed.

**Claims**

1. Semi-transparent bifacial photovoltaic module with irradiance concentrators comprising

   - a front glass cover (1),
   - a matrix of bifacial cells (2), wherein each cell is separated from others by a separation area and the cells are electrically interconnected to obtain a two-wire electrical power output,
   - a rear glass cover (4);

   **characterized in that** it also includes

   - an array of rear refractive concentrators (3), wherein each concentrator corresponds to each cell with its minor edge facing said cell and its major edge facing the rear cover (4) and away from the front cover (1).

2. The semi-transparent bifacial photovoltaic module of claim 1, wherein the subsequent refractive concentrators are of the crossed compound parabolic type (9).

3. The semi-transparent bifacial photovoltaic module of claim 1, wherein the subsequent refractive concentrators are of the compound parabolic type (10).

4. The semi-transparent bifacial photovoltaic module of claim 1, wherein the subsequent refractive concentrators are of the compound parabolic type with lens walls (11).

5. The semi-transparent bifacial photovoltaic module of claim 1, wherein the subsequent refractive concentrators are of the crossed V channel type (12).

6. The semi-transparent bifacial photovoltaic module of claim 1, wherein the subsequent refractive concentrators are of the polygonal compound parabolic type (13).

7. The semi-transparent bifacial photovoltaic module of claim 1, wherein the subsequent refractive concentrators are of the square elliptical hyperboloid type (14).

8. The semi-transparent bifacial photovoltaic module of claim 1, wherein the subsequent refractive concentrators are of the compound parabolic revolution type (8).

5   6

1

2

3

4

7

FIG. 1

8          9          10         11         12         13         14

FIG. 2

FIG. 3

| INTERNATIONAL SEARCH REPORT | International application No. |
|---|---|
| | PCT/ES2022/070353 |

**A. CLASSIFICATION OF SUBJECT MATTER**

*H01L31/054* (2014.01)
*H01L31/068* (2012.01)
According to International Patent Classification (IPC) or to both national classification and IPC

**B. FIELDS SEARCHED**

Minimum documentation searched (classification system followed by classification symbols)
H01L

Documentation searched other than minimum documentation to the extent that such documents are included in the fields searched

Electronic data base consulted during the international search (name of data base and, where practicable, search terms used)

EPODOC, INVENES, INSPEC, XPESP, XPIEE, XPI3E

**C. DOCUMENTS CONSIDERED TO BE RELEVANT**

| Category* | Citation of document, with indication, where appropriate, of the relevant passages | Relevant to claim No. |
|---|---|---|
| A | US2010024866 (GEN ELECTRIC [US]) 04/02/2010, Paragraphs [0012]-[0019]; figure 1 | 1-8 |
| A | FR3042345 (ATHELIOS [FR]) 14/04/2017, Page 2, line 11-line 52; figure 1 | 1-8 |
| A | WO2013010313 (SOLAR ENERGY & MATERIALS INCORPORATE LTD [CN]; LIU REYNOLD J L [CN]) 24/01/2013, Abstract; figure 7B | 1-8 |
| A | US5538563 (FINKL) 23/07/1996, column 2, line 66- column 3, line 56; Figures 1 and 2. | 1-8 |

☒ Further documents are listed in the continuation of Box C.　　☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | |
| | "&" document member of the same patent family |

| Date of the actual completion of the international search | Date of mailing of the international search report |
|---|---|
| 13/09/2022 | **(14/09/2022)** |

| Name and mailing address of the ISA/ | Authorized officer |
|---|---|
| | L. García Aparicio |
| OFICINA ESPAÑOLA DE PATENTES Y MARCAS Paseo de la Castellana, 75 - 28071 Madrid (España) | |
| Facsimile No.: 91 349 53 04 | Telephone No. 91 3493057 |

Form PCT/ISA/210 (second sheet) (January 2015)

## INTERNATIONAL SEARCH REPORT

International application No.

PCT/ES2022/070353

C (continuation).                    DOCUMENTS CONSIDERED TO BE RELEVANT

| Category * | Citation of documents, with indication, where appropriate, of the relevant passages | Relevant to claim No. |
|---|---|---|
| A | ORTABASI U . Performance of a 2/spl times/ Cusp concentrator PV module using bifacial solar cells. Conference Record Of The 26th Ieee Photovoltaic Specialists Conference - 1997. Pvsc '97. Anaheim, Ca, Sept. 29 - Oct. 3, 1997; [ieee Photovoltaic Specialists Conference], 29/09/1997, pages 1177 - 1181 , ISSN ISBN 978-0-7803-3767-1 ; ISBN 0-7803-3767-0 , <DOI: 10.1109/PVSC.1997.654299> | 1-8 |

Form PCT/ISA/210 (continuation of second sheet) (January 2015)

## INTERNATIONAL SEARCH REPORT

Information on patent family members

| International application No. |
| --- |
| PCT/ES2022/070353 |

| Patent document cited in the search report | Publication date | Patent family member(s) | Publication date |
| --- | --- | --- | --- |
| US2010024866 A1 | 04.02.2010 | NONE | |
| FR3042345 A1 | 14.04.2017 | NONE | |
| WO2013010313 A1 | 24.01.2013 | NONE | |
| US5538563 A | 23.07.1996 | NONE | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5538563 A, Anthony W. Finkl
- US 20120097213 A1
- US 4169738 A, Antonio Luque. A
- US 20100126556 A1
- EP 1732141 A1
- DE 202014105516
- US 20160284914 A1

**Non-patent literature cited in the description**

- **KANGMIN LEE et al.** The Development of Transparent Photovoltaics. *Cell Reports Physical Science,* 26 August 2020, vol. 1, 100143
- **SHANKS et al.** Optics for concentrating photovoltaics: Trends, limits and opportunities for materials and design. *Renewable and Sustainable Energy Reviews,* 2016, vol. 60, 394-407